# EUROPEAN PATENT APPLICATION

(11) **EP 4 841 673 A1**
(43) Date of publication of application: **18.11.2026**
(21) Application number: 25176098.9
(22) Date of filing: 13.05.2025
(51) Int. Cl.: H01L 21/02, H01L 21/762

(54) **A DONOR WAFER SUITABLE FOR THE PRODUCTION OF ENGINEERED SUBSTRATES**

(71) Applicant: IMEC VZW, 3001 Leuven (BE)
(72) Inventor: Kunert, Bernardette, 4851 Gemmenich (BE); Collaert, Nadine, 3052 Blanden (BE); Vais, Abhitosch, 3001 Leuven (BE); Alcotte, Reynald, 1000 Brussels (BE); Boccardi, Guillaume, 1200 Sint-Lambrechts-Woluwe (BE); Mols, Yves, 2110 Wijnegem (BE); Yadav, Sachin, 3001 Leuven (BE); Kumar, Annie, 3001 Leuven (BE); Parvais, Bertrand, 1457 Nil-Saint-Vincent (BE); Charcerel, François, 1000 Brussels (BE); Miller, Robert, 3210 Lubbeek (BE)
(74) Representative: Patent Department IMEC

(57) **Abstract**

The donor wafer comprises structures (11) embedded in trenches (10) formed in a template layer (2, 3, 5) that lies on top of a support substrate (1). The support substrate (1) and the structures (11) are formed of different semiconductor materials. The structures (11) comprise a planar bonding surface (13), with all the bonding surfaces of the structures being coplanar. The upper surface of the template layer (2, 3, 5) is recessed relative to the bonding surfaces (13), so that stripe portions (12) of the structures (11) extend outward from the recessed template layer (2, 3, 5). The structures (11) comprise a release layer (15) that enables bonding the structures to a carrier substrate (20) and releasing the release layer to thereby transfer at least an upper part (12') the stripe portions (12) to the carrier substrate (20). The donor wafer is produced by growing the material of the structures (11) in a manner that enables trapping of threading dislocations so that the structures exhibit high crystal quality in the transferred part of the stripe portions. (12)

## Description

### Field of the Invention

The present invention is related to semiconductor processing, in particular to the manufacturing and use of engineered substrates.

### State of the art.

Engineered substrates in semiconductor fabrication are substrates composed of a carrier substrate and a crystalline semiconductor layer bonded thereto and suitable as a seed layer for epitaxial growth of additional layers required for the fabrication of semiconductor devices. Various types of engineered substrates are known, for example comprising a III-V semiconductor layer bonded to a crystalline Si substrate, or to a polycrystalline Si substrate, or to a polycrystalline AIN substrate, or to a polycrystalline SiC substrate.

The application of engineered substrates is particularly useful for the integration of III-V devices onto large-diameter substrates, preferably Si substrates but not exclusively. For example, III-V device fabrication on 200/300 mm large-diameter Si wafers enables access to mature Si foundries and helps reduce production costs. Additionally, it allows for the co-integration of III-V devices with Si-based functionalities using large-diameter Silicon photonic or CMOS wafers optional via wafer-to-wafer bonding.

As known in the art, this type of engineered substrate can be produced for example by bonding a bulk III-V substrate to the handle wafer and thereafter splitting a thin layer of III-V material from the bulk wafer by the effect of a preliminary ion implant in the bulk III-V wafer. This method, trademarked as Smart Cut^{™}, by Soitec, has been well-developed for the transfer of Si layers to large-diameter SiO2/Si wafers to produce silicon-on-insulator (SOI) substrates as well as for InP layers from a 100 mm diameter InP bulk wafer to Si for example. Larger InP-on-Si substrates, often referred to as InPOSi substrates, can be produced by the same Smart Cut^{™} method after bonding multiple InP tiles to a large, for example 200 mm or 300 mm diameter Si handle wafer.

The fabrication of crystalline bulk wafers of III-V or similar semiconductor materials is however expensive and there is therefore a need for more sustainable methods of fabricating engineered substrates.

### Summary of the invention

The invention provides a novel type of donor wafer that can be applied in the manufacturing of engineered substrates, i.e. substrates composed of a carrier substrate and a crystalline semiconductor layer bonded thereto and suitable as a seed layer for epitaxial growth of additional layers required for the fabrication of semiconductor devices. In accordance with the appended claims, the invention is related to the donor wafer as such, to methods of fabricating the donor wafer and of re-using the donor wafer after a first or subsequent use, and to methods of producing an engineered substrate using a donor wafer according to the invention.

A donor wafer according to the invention comprises structures embedded in trenches formed in a template layer, that lies on top of a support substrate formed of a first crystalline semiconductor material. A template layer is defined within the present description as a layer provided with trenches through the full thickness of the template layer. The template layer is formed of a material or materials different from the support substrate and enabling selective area growth of a second semiconductor material from the bottom of the trench upwards (i.e. the second material grows on the first material and not on the material of the template layer). The structures comprise a planar bonding surface, with all the bonding surfaces of the structures being coplanar. The upper surface of the template layer is recessed relative to the bonding surfaces, so that stripe portions of the structures extend outward from the recessed template layer surface. The structures comprise a release layer positioned between a bulk portion of the structures and at least an upper part of the stripes. The release layer enables bonding the structures to a carrier substrate and releasing the release layer to thereby transfer said at least upper part of the stripe portions to the carrier substrate. The donor wafer is produced by growing the material of the structures in a manner that enables confining and trapping of threading dislocations so that the structures exhibit high crystal quality in the transferred part of the stripe portions. The high quality can be quantified by preferred maximum values of the threading dislocation density (TDD) measured on the planar bonding surfaces of the structures prior to transfer.

A donor wafer according to the invention is advantageous with respect to the prior art because no bulk wafer formed of the donor material is required.

The invention is in particular related to a donor wafer for the production of engineered semiconductor substrates, the donor wafer comprising:
- a support substrate formed of a first crystalline semiconductor material,
- a template layer on the support substrate, the template layer comprising a plurality of trenches, through the full thickness of the template layer,
- a plurality of structures respectively disposed in said trenches, and formed of a second crystalline semiconductor material,
and wherein:
- each structure of the plurality of structures comprises a planar bonding surface, with all the bonding surfaces of the structures being coplanar,
- the upper surface of the template layer is recessed relative to said bonding surfaces, so that stripe portions of the structures extend outward from the recessed upper surface of the template layer,
- each structure of the plurality of structures comprises a release layer positioned so as to enable transferring at least an upper part of the stripe portions, to a carrier substrate.

According to an embodiment, said trenches comprise a base portion and an upper portion, the upper portion being wider than the base portion.

According to an embodiment, the aspect ratio of both the base portion and the upper portion of the trenches is equal to or higher than 2.

According to an embodiment, the height of the stripe portions is between 10 nm and 1 µm.

According to an embodiment, the first semiconductor material is silicon and the second semiconductor material is a group III-V or group IV semiconductor material.

According to an embodiment, the width of said stripe portions of the structures is between 0.5 µm and 20 µm.

According to an embodiment, the threading dislocation density measured on said planar bonding surfaces of the structures is lower than 5E8 cm⁻².

According to an embodiment, the threading dislocation density measured on said planar bonding surfaces of the structures is lower than 1E7 cm⁻².

The invention is also related to a method for producing a donor wafer according to the invention, the method comprising the steps of :
- providing a support substrate formed of the first crystalline semiconductor material,
- producing said template layer on the support substrate, wherein the template layer comprises a plurality of trenches through the full thickness of the template layer, the trenches having a base portion and an upper portion, wherein:
   ∘ the upper surface of the support substrate is exposed at the bottom of said base portion of the trenches, and
   ∘ the upper portion of the trenches is wider than the base portion,
- by epitaxial growth, growing said structures formed of the second semiconductor material upward from the bottom of the base portions of the trenches, said structures growing upward and out of said base portions so as to become embedded in the upper portions of the trenches, wherein the crystal orientation and shape of said bottom of the base portions and the aspect ratio of the base portions are configured to enable aspect ratio trapping of threading dislocations in said base portions,
- continuing said epitaxial growth until said structures extend outward from the upper portions of the trenches,
- thereafter performing a planarization, thereby making the upper surfaces of the structures and of the template layer coplanar, and thereby creating said coplanar bonding surfaces of the structures,
- thereafter recessing the template layer relative to the structures to create said stripe portions extending outward from the recessed template layer,
- implanting ions in the structures, to thereby create said release layer.

According to an embodiment, the method for producing said donor wafer further comprises the step of forming a dielectric bonding layer conformally on the topography defined by the stripe portions and the surface of the recessed template layer.

According to an embodiment, said implanting step is performed after the step of forming the dielectric bonding layer. According to another embodiment, said implanting step is performed before the step of forming the dielectric bonding layer.

The invention is also related to a method for producing an engineered substrate using a donor wafer according to the invention, the method comprising the steps of:
- if the donor wafer does not already comprise a dielectric bonding layer formed conformally on the topography defined by the stripe portions and the surface of the recessed template layer, producing said dielectric bonding layer on said topography,
- bonding the donor wafer to a carrier substrate by bonding the bonding layer to the carrier substrate,
- thereafter, releasing the release layer to thereby transfer at least an upper part of the stripe portions of the structures to the carrier substrate,
- depositing a dielectric material on the carrier substrate, thereby filling the spaces between the transferred parts of the stripe portions,
- performing a planarization, making the surface of the transferred parts of the stripe portions coplanar with said dielectric material, thereby obtaining the engineered substrate.

The invention is also related to a method for preparing a donor wafer according to the invention for re-use, after a first or subsequent use of said donor wafer in the production of an engineered substrate by a method according to the invention, the method comprising:
- planarizing the donor wafer, thereby making the upper surfaces of the structures and of the template layer or the bonding layer coplanar,
- recessing the template layer and/or the bonding layer relative to the structures, to obtain again stripe portions of the structures extending outward from the recessed upper surface of the template layer,
- implanting ions in said structures to create again a release layer.

The invention is also related to a method for preparing a donor wafer according to the invention for re-use, after a first or subsequent use of said donor wafer in the production of an engineered substrate by a method according to the invention, the method comprising:
- by selective epitaxial growth, growing the second semiconductor material on the released structures to thereby obtain again stripe portions of the structures, extending outward from the recessed template layer,
- implanting ions in said structures to create again a release layer.

### Brief description of the figures

Figures 1 to 11 illustrate a method according to an embodiment of the invention, for producing a donor wafer.
Figures 12 to 14 illustrate a method for producing an engineered substrate with the use of the donor wafer as produced by the method illustrated in Figures 1-9.
Figures 15 to 17 illustrate different methods of re-using the donor wafer.

### Detailed description of the invention

A number of embodiments will be described in detail. Any reference to dimensions or materials is purely exemplary and does not limit the scope of the invention.

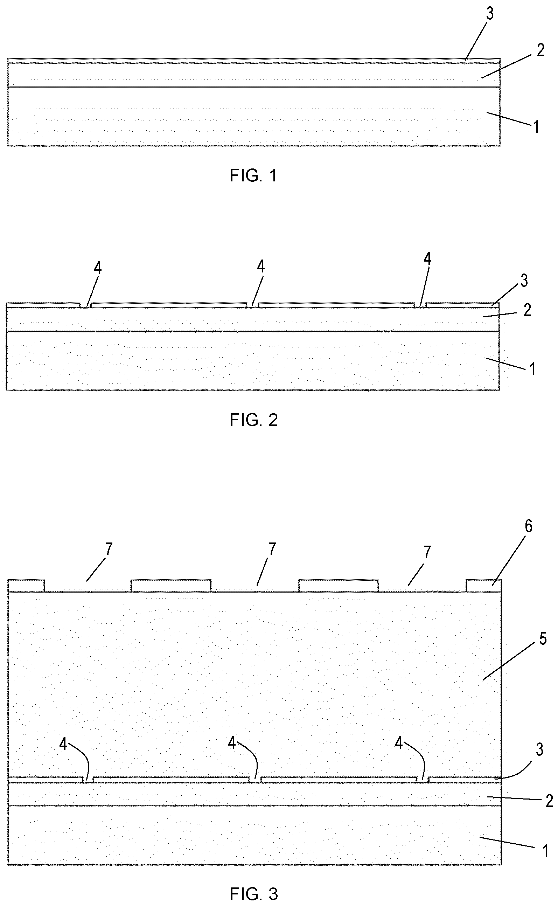

First a method for producing a donor wafer according to an embodiment will be described. With reference to Figure 1, a crystalline silicon wafer 1 is provided. This may be a standard Si process wafer of several hundreds of micrometres in thickness and up to 300 mm in diameter. The image in Figure 1 shows only a thin upper portion of the wafer 1 in a section view of a small wafer segment.

On the front side of the wafer 1, a stack of a first and second layer 2,3 is produced. The first layer 2 may be formed of a dielectric material, for example silicon oxide (SiO2) and can be produced by thermal oxidation or by a deposition technique such as Chemical Vapour Deposition (CVD). The first layer 2 is about 0.6 µm thick. The second layer 3 is less than 0.2 µm thick and will serve as a mask layer. The material of this layer may be for example silicon nitride (SiN), amorphous Si or aluminium oxide (Al₂O₃), applied by any known method for producing a layer of these materials.

On the back side of the wafer 1 (not shown), a stress compensation layer may be produced. This could be a layer of silicon oxide or silicon nitride with an adjusted strain state for compensating strain caused by the layers produced on the front side. The skilled person is aware of the required thickness and material requirements for such a strain compensation layer.

The mask layer 3 is patterned as shown in Figure 2, forming narrow enlongated openings 4 therein, which can be realized by standard lithography and etching techniques. The width of the openings 4 is about 0.3 µm. In the length direction, the openings 4 may extend in the order of hundreds of micrometres or in the order of millimetres.

With reference to Figure 3, a second dielectric layer 5 is produced having a thickness of about 5.4 µm, followed by a further mask layer 6 that is subsequently patterned to form wider elongated openings 7 aligned to the narrow openings 4. The further mask layer 6 may be formed of the same material as the first mask layer, or from another material suitable for the same purpose. The wider openings 7 are essentially concentric with the narrower openings 4, the term 'essentially' allowing some deviation that falls within the overlay accuracy of the lithographic process applied for patterning the further mask layer 6. The second dielectric layer 5 may also be a layer of silicon oxide, produced for example by CVD.

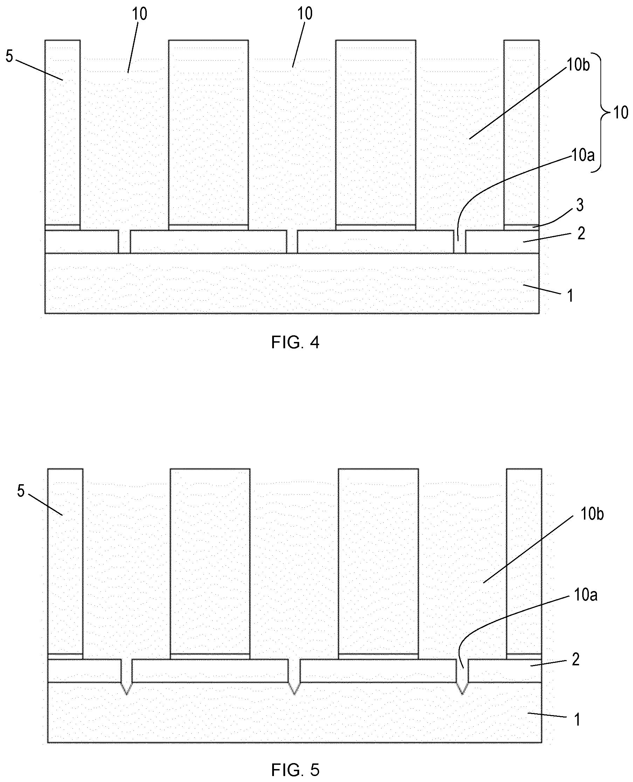

With reference to Figure 4, the pattern of wider openings 7 is transferred to the second dielectric layer 5 by anisotropic etching. Thereafter, the narrower openings 4 are transferred to the first dielectric layer 2. In Figure 4, no mask material remains on the horizontal surfaces exposed to the anisotropic etch species applied for transferring the openings. It is possible that the mask layers are consumed during the anisotropic etch processes and thus removed from the horizontal surfaces. It is also possible that some of the mask material remains and is stripped after the transfer of the openings. If mask material remains however, it is also possible to leave it in place and proceed with the method as described hereafter.

The result of transferring the openings 4 and 7 is that parallel trenches 10 are formed through the stack of layers 2, 3, 5, the trenches having a narrow base portion 10a and a wider upper portion 10b.

In the example shown, the width of the narrow base portion 10a is about 0.3 µm, and the height of the narrow base portion is about 0.6 µm. The width of the upper portion 10b is about 2.5 µm while the height of the upper portion is about 5.4 µm. The aspect ratio of both the base and the upper portion is about 2. According to other embodiments, the width of the base portion 10a may be between 0.1 and 0.5 µm while the height of the base portion may be between 0.2 µm and 2 µm. The width of the upper portion 10b may be between 0.5 µm and 20 µm, while the height of the upper portion may be between 1 µm and 40 µm. Preferably, the aspect ratio of the base portion 10a is at least equal to or higher than 2. According to further embodiments, the aspect ratio of the upper portion 10b of the trenches is also at least equal to or higher than 2. The trenches 10 preferably all have the same dimensions and are arranged at regular spacings from each other, although the invention is not limited to such embodiments.

The image shows only a small portion of the wafer 1 comprising three trenches 10 which are however part of an array of a larger number of preferably equally spaced parallel trenches. The length of the trenches may be in the order of hundreds of micrometres or in the order of millimetres. Any manner of arranging the arrays of trenches on the wafer 1 is covered by the general concept of the invention. However, the arrays of trenches 10 are preferably oriented along two orthogonal directions on the wafer, with about equal numbers of trenches oriented in both directions.

As seen in Figure 4, at the bottom of the base portion 10a of the trenches, the surface of the Si wafer 1 is exposed. As illustrated in Figure 5, the wafer is subjected to an etching step wherein the bottom of the trenches is etched, forming a V-shaped bottom. This is achievable by a wet etching process when the Si wafer 1 is a (100) oriented Si substrate and the trenches are oriented along <011>. The inclined surfaces are then defined by the {111} Si crystal facets.

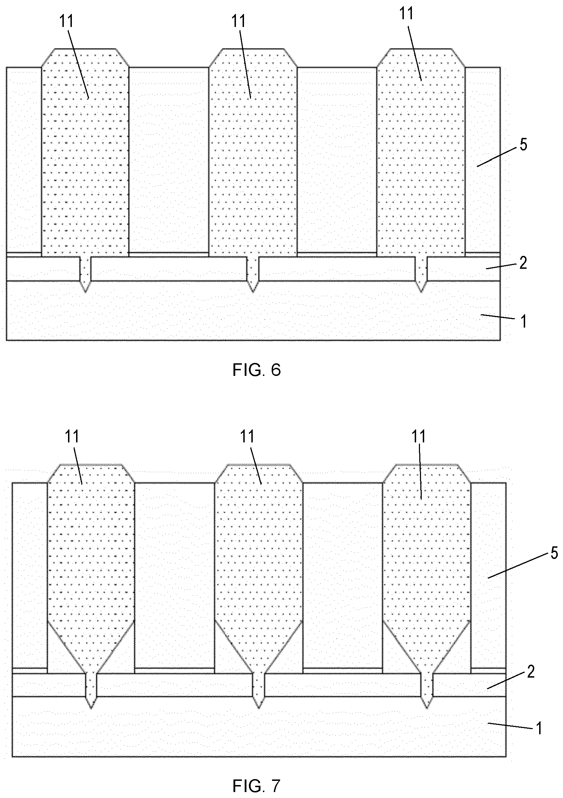

Thereafter, a layer is grown selectively by epitaxial growth on the exposed silicon surface at the bottom of the trenches. In the embodiment shown, this may be a layer of III-V semiconductor material that exhibits a significant lattice mismatch and thermal expansion coefficient mismatch compared to crystalline silicon. The material may for example be grown by metal organic vapour phase epitaxy (MOVPE) applying known parameters and tools. The material grows selectively on the Si and not on the SiO₂. Applying optimized growth conditions which enhance strain relaxation along the inclined growth surface and enable efficient threading dislocation gliding, due to the high aspect ratio of the base portion 10a of the trenches, threading dislocations are confined and trapped in said base portion 10a, and high quality III-V material, i.e. material exhibiting low threading dislocation density, grows out of the base portions 10a and becomes embedded in the upper portions 10b of the trenches formed in the stack of layers 2,3,5, which is hereafter referred to as a template layer. As shown in Figure 6, the epitaxial growth results in the formation of structures 11 embedded in the trenches 10 and exhibiting low threading dislocation density in an upper region of the structures. Preferred maximum values of said density will be provided further in this text. When the upper portion 10b exhibits a high aspect ratio (preferably > 2), this high aspect ratio provides an additional defect trapping effect in case not all defects are confined in the base portion 10a.

The growth of the structures 11 can be more readily understood from document EP3789519A1, where for example details and examples of parameters and tools applicable in this technology can also be found. The manner in which the material grows out of the base portion 10a of the trenches may depend on the material and on specific growth parameters. Some materials fill the upper portion 10b of the trenches completely as shown in Figure 6, while others exhibit faceted growth with a specific shape defined by the facet, as illustrated in Figure 7 in case of a {111} facet. Both options are possible within the scope of the invention.

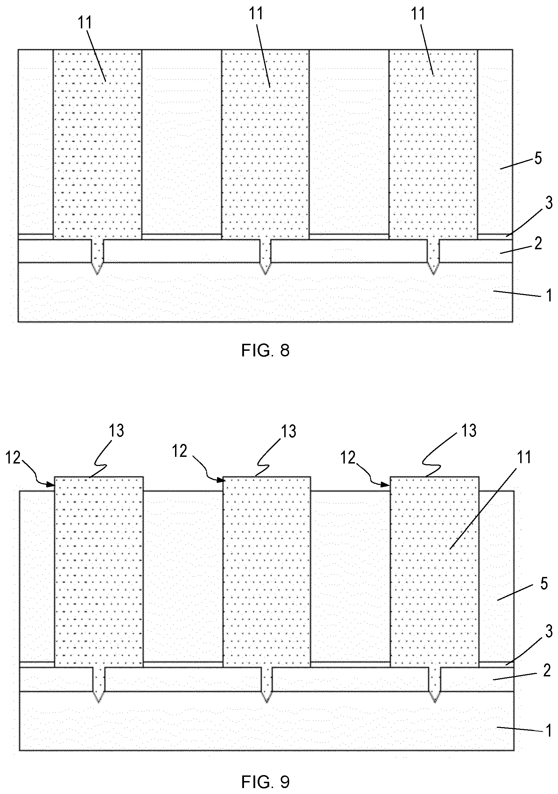

The growth of the structures 11 continues until the structures extend outward from the upper portion of the trenches 10. Thereafter, a planarization is applied, as illustrated in Figure 8. The upper surfaces of the structures 11 are planarized to a common level with the upper surface of the template layer 2,3,5. Planarization as applied within the present description may apply any known method for rendering an uneven surface planar, such as grinding or polishing, including CMP techniques (Chemical Mechanical Polishing).

Thereafter, the template layer 2, 3, 5 is recessed, i.e. etched back relative to the structures 11, by a selective etch process, as illustrated in Figure 9. The structures 11 now extend outward from the recessed surface of the template layer 2,3,5, forming parallel stripe portions 12 (hereafter also referred to as 'stripes'). The height of the stripes 12, i.e. the distance between the recessed surface of the template layer 2, 3, 5 and the planar upper surface of the structures 11 may be in the order of a few hundred nanometres, for example between 10 nm and 1 micrometre. The planarized surfaces 13 of the structures 11 (and of the stripes 12) are referred to as bonding surfaces, as these surfaces are to be bonded to a carrier wafer in a process for producing an engineered substrate (as described further in this text). The bonding surfaces 13 of the structures 11 are all coplanar.

On the donor wafer as shown in Figure 9, the high crystal quality in an upper region of the structures 11 can be expressed in terms of the threading dislocation density (TDD) as measured on the bonding surfaces 13 of the structures 11. Preferred maximum values of the TDD may differ depending on the material of the structures 11. For example, for grown structures 11 formed of group-IV alloys or III-V semiconductors preferentially forming zinc blend crystal structure (e.g. GaAs, InP, GaSb, InAs) the TDD measured on the bonding surfaces 13 is preferably lower than 1E7 cm⁻². For III-V semiconductors preferentially forming wurtzite crystal structure (e.g. GaN) a TDD of below 5E8 cm⁻² (measured on the bonding surfaces 13) is preferred.

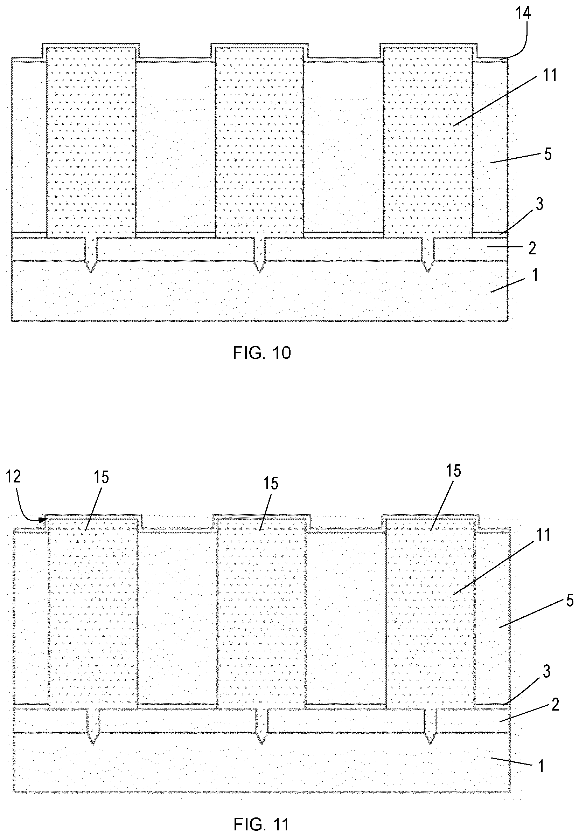

Then, with reference to Figure 10, a bonding layer 14 is produced conformally on the recessed surface of the template layer 2, 3, 5 and on the stripes 12, i.e. the bonding layer 14 follows the topography defined by the stripes 12 and the recessed surface. The bonding layer 14 may be a dielectric layer suitable for direct dielectric-to-dielectric bonding techniques, for example a layer formed of SiCN, SiO₂, SiC, Al₂O₃ or AIN.

This is followed by an ion implantation step illustrated in Figure 11, which may be performed in accordance with the similar practice of implanting ions in a bulk III-V wafer in order to perform the Smart Cut^{™} method. A thin layer of ions is implanted through the planar bonding surfaces of the stripes 12, forming a buried release layer 15. The release layer defines an interface between an upper part of the stripes 12 and the bulk of the structures 11. The depth of the implanted layer 15 from the planar surface of the structures 11 is close to but less than the height of the stripes 12. In an alternative embodiment, the ion implantation is performed before producing the bonding layer 14. In another alternative embodiment, the ion implantation is performed after planarizing the structures 11 and before recessing the surface of the template layer 2, 3, 5.

A donor wafer according to the invention is thus characterized by the presence of the structures 11 embedded in trenches 10 formed in a template layer 2, 3, 5 that lies on top of a support substrate 1. The support substrate 1 and the structures 11 are formed of different semiconductor materials. The material of the structures 11 exhibits low threading dislocation density in an upper region of the structures 11. The structures 11 comprise a planar bonding surface 13, with all the bonding surfaces of the structures being coplanar. The surface of the template layer 2, 3, 5 is recessed relative to said bonding surfaces 13, so that stripe portions 12 of the structures extend outward from the recessed template layer 2,3,5. The structures comprise a release layer 15 that enables bonding the structures to a carrier substrate and releasing the release layer to thereby transfer at least an upper part of the stripe portions 12 to the carrier substrate. The donor wafer may further comprise a bonding layer 14.

The benefit of a donor wafer according to the invention compared to prior art donor wafers is that no bulk wafer of the transferred material is required. The material is grown on the donor wafer, and the donor wafer's structure, comprising proliferated stripes extending outward from a recessed template layer, enables multiple re-uses, as will be described further in this text.

In the embodiment described hereabove and illustrated in the drawings, the manner in which the template layer is produced is different from the approach disclosed in EP3789519A1. In the latter disclosure, the so-called shallow trench isolation (STI) method is applied for isolating narrow fin-shaped portions of silicon between oxide regions. The fin shaped portions are etched back in order to create the high-aspect ratio trenches required for trapping the threading dislocations.

The use of STI for producing a donor wafer in accordance with the invention is not excluded from the invention scope. However, in the above-described method illustrated in the drawings, STI is not applied. Instead, a layer stack is patterned to form the template layer 2, 3, 5. This enables larger dimensions of the trench widths, so that the width of the upper portions of the structures 11 can be higher compared to structures obtained using STI. This width can be between 0.5 µm and 20 µm according to embodiments of the invention. In this way, a significant portion of the donor wafer surface can be transferred in a process for producing engineered substrates.

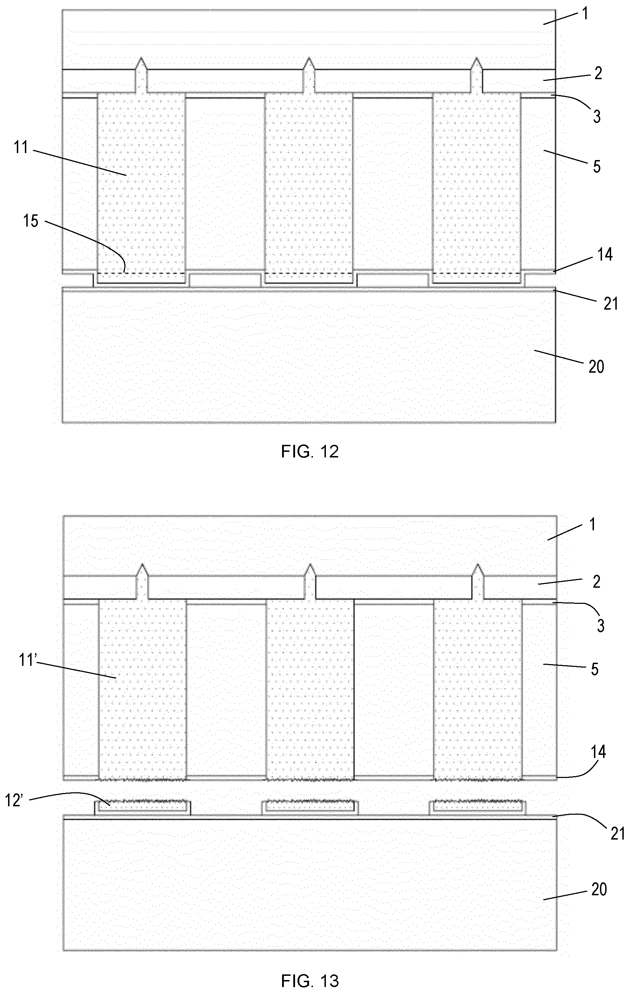

Such a process for producing an engineered substrate using the donor wafer as shown in Figure 11 is illustrated in Figures 12 to 14. A Si carrier wafer 20 is provided which may be a process wafer of the same diameter as the donor wafer. The carrier wafer 20 is provided with a dielectric bonding layer 21 on its surface, which is preferably formed of the same material as the bonding layer 14 formed on the donor wafer. As shown in Figure 12, the donor wafer is aligned to the carrier wafer 20 and bonded thereto by a known direct dielectric-to-dielectric bonding method.

Thereafter, the assembly of the carrier wafer 20 and the bonded donor wafer is subjected to so-called split annealing, i.e. temperature is raised to a given level suitable for releasing the donor wafer at the interface defined by the implanted ion layer 15, as illustrated in Figure 13.

The result is the transfer of a portion 12' of the stripes 12 to the carrier wafer, while bulk portions 11' of the structures 11 remain embedded in the template layer 2, 3, 5. The position of the release layer 15 is such that at least an upper part 12' of the stripes 12 is transferred. As illustrated, the position of the release layer 15 is preferably such that the stripes 12 are essentially fully transferred, i.e. the thickness of the transferred portions 12' is essentially equal or very close to the thickness of the stripes 12 prior to transfer.

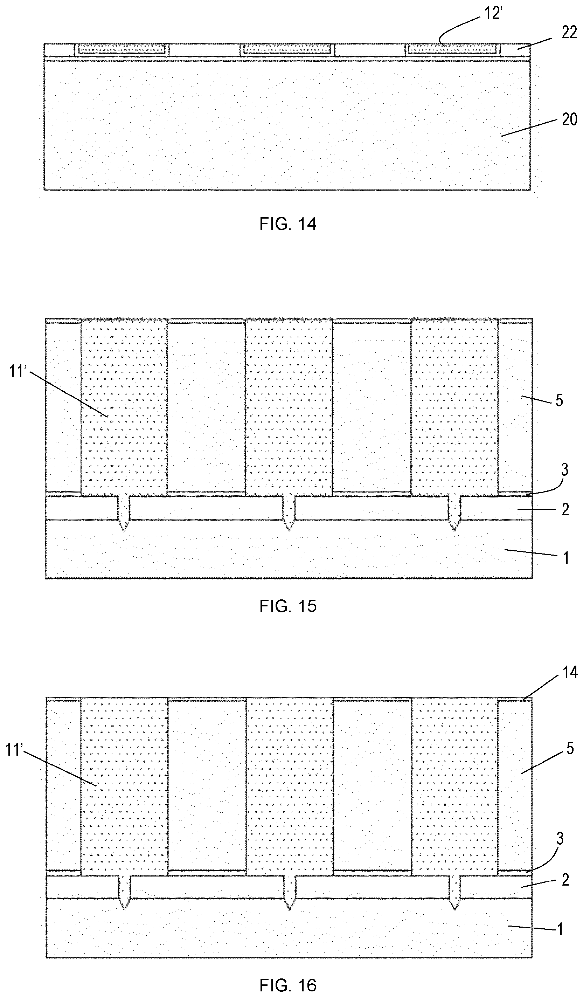

Thereafter, a dielectric material 22 is deposited on the carrier wafer 20, filling the spaces between the transferred stripe portions 12' and covering said stripe portions, followed by a planarization until the stripe portions 12' are exposed and coplanar with the dielectric 22, as illustrated in Figure 14.

It is expected that after the split annealing, the surfaces of the stripe portions 12' and of the remaining bulk structures 11' exhibit high roughness. On the carrier wafer 20, this roughness is reduced by the planarization step which brings the upper surfaces of the planarized stripes 12' to the same level as the dielectric 22, thereby completing the fabrication of the engineered substrate comprising a carrier wafer 20 and high-quality material of the structures 11, which can for example be a III-V material available on the surface of the engineered substrate in the form of the parallel stripes 12'. Threading dislocation density as measured in the surfaces of the planarized strips 12' may for example be below 1E7 cm⁻² for III-V material. The engineered substrate can be used as a process wafer applicable in Si-based fabrication technology.

After the transfer of the stripe portions 12', the donor wafer can be re-used. A number of different possibilities are available. According to one embodiment illustrated in Figures 15 and 16, the donor wafer is planarized until the upper surfaces of the structures 11' are again at the same level with the template layer. The bonding layer 14 may remain on the template layer at this point, as shown in the drawing, or the bonding layer 14 may be removed by the planarization. The donor wafer is then again ready to undergo the steps shown in Figures 9 to 11. This can be repeated a number of times, until the high-quality material of the structures 11 is consumed.

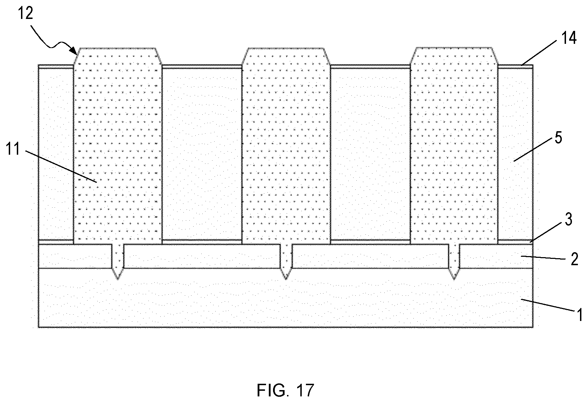

According to another embodiment, the material is re-grown on the remaining bulk structures 11' after the transfer of the stripes. This is illustrated in Figure 17. The way in which the material grows is material-dependent and may be faceted so that the material grows along inclined surfaces as shown. Before regrowth, a pretreatment is preferably performed, which may be a baking step together with an in situ etch step in a vapour phase before growth to remove native oxides which have formed on the surface due to exposure to air and to smoothen the surface before regrowth. Planarizing the donor prior to regrowth is also possible, wherein the bonding layer 14 may be removed by the planarization. The regrowth again forms stripes 12 which can be transferred in the same way as described above.

Two recycling methods are thereby identified: the first method involves planarization followed by further recessing the template layer 2,3,5; the second method involves regrowth of the material. It is also possible to use the two recycling methods alternatingly or in any given sequence of re-use cycles.

## Claims

1. A donor wafer for the production of engineered semiconductor substrates, the donor wafer comprising:
- a support substrate (1) formed of a first crystalline semiconductor material,
- a template layer (2, 3, 5) on the support substrate (1), the template layer comprising a plurality of trenches (10), through the full thickness of the template layer,
- a plurality of structures (11) respectively disposed in said trenches, and formed of a second crystalline semiconductor material,
and wherein:
- each structure of the plurality of structures (11) comprises a planar bonding surface (9), with all the bonding surfaces of the structures being coplanar,
- the upper surface of the template layer (2, 3, 5) is recessed relative to said bonding surfaces (13), so that stripe portions (12) of the structures extend outward from the recessed upper surface of the template layer,
- each structure of the plurality of structures (11) comprises a release layer (15) positioned so as to enable transferring at least an upper part (12') of the stripe portions (12), to a carrier substrate.

2. The donor wafer according to claim 1, wherein said trenches (10) comprise a base portion (10a) and an upper portion (10b), the upper portion being wider than the base portion.

3. The donor wafer according to claim 2, wherein the aspect ratio of both the base portion (10a) and the upper portion (10b) of the trenches is equal to or higher than 2.

4. The donor wafer according to any one of the preceding claims, wherein the height of the stripe portions (12) is between 10 nm and 1 µm.

5. The donor wafer according to any one of the preceding claims, wherein the first semiconductor material is silicon and the second semiconductor material is a group III-V or group IV semiconductor material.

6. The donor wafer according to any one of the preceding claims, wherein the width of said stripe portions (12) of the structures (11) is between 0.5 µm and 20 µm.

7. The donor wafer according to any one of the preceding claims, wherein the threading dislocation density measured on said planar bonding surfaces (13) of the structures (11) is lower than 5E8 cm⁻².

8. The donor wafer according to any one of the preceding claims, wherein the threading dislocation density measured on said planar bonding surfaces (13) of the structures (11) is lower than 1E7 cm⁻².

9. A method for producing a donor wafer according to any one of the preceding claims, comprising the steps of :
- providing a support substrate (1) formed of the first crystalline semiconductor material,
- producing said template layer (2, 3, 5) on the support substrate (1), wherein the template layer comprises a plurality of trenches (10) through the full thickness of the template layer, the trenches having a base portion (10a) and an upper portion (10b), wherein:
∘ the upper surface of the support substrate (1) is exposed at the bottom of said base portion (10a) of the trenches (10), and
∘ the upper portion (10b) of the trenches is wider than the base portion (10a),
- by epitaxial growth, growing said structures (11) formed of the second semiconductor material upward from the bottom of the base portions (10a) of the trenches, said structures growing upward and out of said base portions (10a) so as to become embedded in the upper portions (10b) of the trenches, wherein the crystal orientation and shape of said bottom of the base portions (10a) and the aspect ratio of the base portions (10a) are configured to enable aspect ratio trapping of threading dislocations in said base portions (10a),
- continuing said epitaxial growth until said structures (11) extend outward from the upper portions (10b) of the trenches,
- thereafter performing a planarization, thereby making the upper surfaces of the structures (11) and of the template layer (2, 3, 5) coplanar, and thereby creating said coplanar bonding surfaces (13) of the structures (11),
- thereafter recessing the template layer (2, 3, 5) relative to the structures (11) to create said stripe portions (12) extending outward from the recessed template layer,
- implanting ions in the structures (11), to thereby create said release layer (15).

10. The method according to claim 9, further comprising the step of forming a dielectric bonding layer (14) conformally on the topography defined by the stripe portions (12) and the surface of the recessed template layer (2,3,5).

11. The method according to claim 10, wherein said implanting step is performed after the step of forming the dielectric bonding layer (14).

12. The method according to claim 10, wherein said implanting step is performed before the step of forming the dielectric bonding layer (14).

13. A method for producing an engineered substrate using a donor wafer according to any one of claims 1 to 8, the method comprising the steps of:
- if the donor wafer does not already comprise a dielectric bonding layer (14) formed conformally on the topography defined by the stripe portions (12) and the surface of the recessed template layer (2,3,5), producing said dielectric bonding layer (14) on said topography,
- bonding the donor wafer to a carrier substrate (20) by bonding the bonding layer (14) to the carrier substrate (20),
- thereafter, releasing the release layer (15) to thereby transfer at least an upper part (12') of the stripe portions (12) of the structures to the carrier substrate (20),
- depositing a dielectric material (22) on the carrier substrate (20), thereby filling the spaces between the transferred parts (12') of the stripe portions,
- performing a planarization, making the surface of the transferred parts (12') of the stripe portions (12) coplanar with said dielectric material (22), thereby obtaining the engineered substrate.

14. A method for preparing a donor wafer according to any one of claims 1 to 8 for re-use, after a first or subsequent use of said donor wafer in the production of an engineered substrate by a method according to claim 13, the method comprising:
- planarizing the donor wafer, thereby making the upper surfaces of the structures (11') and of the template layer (2, 3, 5) or the bonding layer (14) coplanar,
- recessing the template layer (2, 3, 5) and/or the bonding layer (14) relative to the structures (11), to obtain again stripe portions (12) of the structures (11) extending outward from the recessed upper surface of the template layer (2,3,5),
- implanting ions in said structures to create again a release layer (15).

15. A method for preparing a donor wafer according to any one of claims 1 to 8 for re-use, after a first or subsequent use of said donor wafer in the production of an engineered substrate by a method according to claim 13, the method comprising:
- by selective epitaxial growth, growing the second semiconductor material on the released structures (11') to thereby obtain again stripe portions (12) of the structures, extending outward from the recessed template layer (2,3,5),
- implanting ions in said structures (11) to create again a release layer (15).
